# DEMANDE DE BREVET EUROPEEN

(11) **EP 4 554 354 A1**
(43) Date de publication de la demande: **14.05.2025**
(21) Numéro de dépôt: 24210583.1
(22) Date de dépôt: 04.11.2024
(51) Int. Cl.: H10D 48/01, H10D 48/00, H10D 64/27, H10D 62/10, H10D 64/01, B82Y 10/00

(54) **DISPOSITIF ÉLECTRONIQUE À QUBITS DE SPIN AVEC DES BOÎTES QUANTIQUES FORMÉES DANS UNE AILETTE VERTICALE PAR DES GRILLES.**

(30) Priorité: 07.11.2023 FR 2312057
(71) Demandeur: Commissariat à l'Energie Atomique et aux Energies Alternatives, 75015 Paris (FR)
(72) Inventeur: BERTRAND, Benoit, 38054 GRENOBLE CEDEX 09 (FR)
(74) Mandataire: Cabinet Beaumont

(57) **Abrégé**

Dispositif électronique (100) comprenant :
- un support (102) ;
- une ailette de semi-conducteur (104) disposée sur une face supérieure du support (102), dans laquelle des boîtes quantiques sont destinées à être formées, et comprenant une première face latérale (108) et une deuxième face latérale (116) opposée à la première face latérale (108) ;
- plusieurs premières grilles de commande (106) disjointes les unes des autres, disposées du côté de la première face latérale (108), les unes au-dessus des autres selon une direction perpendiculaire à la face supérieure du support (102) et définissant différents niveaux de grille, configurées pour commander chacune le potentiel électrostatique d'une des boîtes quantiques;
- au moins une deuxième grille de commande (114) disposée du côté de la deuxième face latérale (116), et configurée pour commander le potentiel électrostatique d'une région de couplage destinée à être formée entre les boîtes quantiques;
dans lequel la ou les grilles de commande (114) disposées du côté de la deuxième face latérale (116) sont décalées, selon la direction perpendiculaire à la face supérieure du support (102), par rapport aux grilles de commande (106) disposées du côté de la première face latérale (108) et définissent un ou plusieurs niveaux de grille chacun interposé entre deux autres niveaux de grille comprenant chacun une des grilles de commande (106) disposées du côté de la première face latérale (108).

## Description

### Domaine technique

La présente description concerne de façon générale le domaine de la spintronique, des dispositifs quantiques et de l'informatique quantique.

### Technique antérieure

Il existe des dispositifs quantiques comportant des qubits basés sur la formation de boîtes quantiques assurant le confinement de charges élémentaires (électrons ou trous). Dans ces dispositifs, l'information quantique est, par exemple, codée sur le spin de ces particules. Les boîtes quantiques sont formées par l'intermédiaire de grilles via lesquelles des potentiels de confinement électriques sont créés dans un matériau semi-conducteur. Ces grilles permettent d'ajuster localement le potentiel électrostatique des boîtes quantiques, c'est-à-dire la profondeur des puits de potentiel des boîtes quantiques. Ces dispositifs peuvent comporter également d'autres grilles contrôlant électriquement le couplage tunnel, c'est-à-dire la hauteur des barrières tunnel, entre les boîtes quantiques voisines.

En pratique, des défauts chargés électriquement sont présents dans les matériaux, par exemple aux interfaces Si-SiO₂ des boîtes quantiques, et perturbent localement le potentiel électrostatique des boîtes quantiques et des barrières tunnel. Le désordre électrostatique généré par ces défauts se superpose aux potentiels électrostatiques générés par les grilles.

Une manière de réduire l'impact de ce désordre électrostatique consiste à réduire le pitch avec lequel les grilles sont réalisées, c'est-à-dire à réduire la longueur et l'espacement entre deux grilles voisines, afin que ce pitch soit plus faible que la longueur caractéristique du désordre pour pouvoir le compenser ou travailler à une échelle plus faible que ce désordre. Néanmoins, le pitch atteignable avec les outils de lithographie disponibles reste insuffisant pour compenser correctement l'impact des défauts chargés électriquement.

Le document WO 2019/125348 A1 décrit un dispositif quantique dans lequel le réseau de qubits est intégré verticalement. Une telle configuration permet de réduire le pitch atteignable par rapport aux dispositifs dans lesquels les grilles sont toutes disposées dans un même plan.

### Résumé de l'invention

Il est proposé un dispositif électronique ne présentant pas un ou plusieurs des inconvénients précédemment décrits, et permettant d'obtenir des valeurs de pitch non atteignables par les structures connues décrites ci-dessus.

Un mode de réalisation propose une solution à tout ou partie des inconvénients des solutions connues et propose un dispositif électronique comprenant :
- un support ;
- une ailette de semi-conducteur disposée sur une face supérieure du support, dans laquelle des boîtes quantiques sont destinées à être formées, et comprenant une première face latérale et une deuxième face latérale opposée à la première face latérale ;
- plusieurs premières grilles de commande disjointes les unes des autres, disposées du côté de la première face latérale, les unes au-dessus des autres selon une direction perpendiculaire à la face supérieure du support et définissant différents niveaux de grille, configurées pour commander chacune le potentiel électrostatique d'une des boîtes quantiques, la première grille de commande la plus proche du support étant disposée dans un niveau de grille N, et la première grille de commande la plus éloignée du support étant disposée dans un niveau de grille N+Z, avec N correspondant à un nombre entier supérieur ou égal à 1, et Z correspondant à un nombre entier supérieur ou égal à 2 ;
- au moins une deuxième grille de commande disposée du côté de la deuxième face latérale, et configurée pour commander le potentiel électrostatique d'une région de couplage destinée à être formée entre les boîtes quantiques ;
dans lequel ladite au moins une deuxième grille de commande est décalée, selon la direction perpendiculaire à la face supérieure du support, par rapport aux premières grilles de commande et définit un niveau de grille interposé entre deux autres niveaux de grille comprenant chacun une des premières grilles de commande.

Il est également proposé un dispositif électronique comprenant :
- un support ;
- une ailette de semi-conducteur disposée sur une face supérieure du support, dans laquelle des boîtes quantiques sont destinées à être formées, et comprenant une première face latérale et une deuxième face latérale opposée à la première face latérale ;
- plusieurs premières grilles de commande disjointes les unes des autres, disposées du côté de la première face latérale, les unes au-dessus des autres selon une direction perpendiculaire à la face supérieure du support et définissant différents niveaux de grille, configurées pour commander chacune le potentiel électrostatique d'une des boîtes quantiques, la première grille de commande la plus proche du support étant disposée dans un niveau de grille N, et la première grille de commande la plus éloignée du support étant disposée dans un niveau de grille N+Z, avec N correspondant à un nombre entier supérieur ou égal à 1, et Z correspondant à un nombre entier supérieur ou égal à 2 ;
- au moins une deuxième grille de commande disposée du côté de la deuxième face latérale, et configurée pour commander le potentiel électrostatique d'une région de couplage destinée à être formée entre les boîtes quantiques ;
dans lequel la ou les grilles de commande disposées du côté de la deuxième face latérale sont décalées, selon la direction perpendiculaire à la face supérieure du support, par rapport aux grilles de commande disposées du côté de la première face latérale et définissent un ou plusieurs niveaux de grille chacun interposé entre deux autres niveaux de grille comprenant chacun une des grilles de commande disposées du côté de la première face latérale.

Selon un mode de réalisation particulier, les premières grilles de commande sont disposées uniquement du côté de la première face latérale, et ladite au moins une deuxième grille de commande est disposée uniquement du côté de la deuxième face latérale.

Selon un mode de réalisation particulier, une première partie de la face supérieure du support sur laquelle sont disposées les premières grilles de commande est décalée, selon la direction perpendiculaire à la face supérieure du support, par rapport à une deuxième partie de la face supérieure du support sur laquelle est disposée la deuxième grille de commande.

Selon un mode de réalisation particulier, le dispositif comporte en outre au moins une première portion diélectrique disposée entre les premières grilles de commande.

Selon un mode de réalisation particulier, le dispositif comporte plusieurs deuxièmes grilles de commande disposées du côté de la deuxième face latérale les unes au-dessus des autres selon la direction perpendiculaire à la face supérieure du support et définissant différents niveaux de grille, configurées pour commander chacune le potentiel électrostatique d'une région de couplage destinée à être formée entre deux des boîtes quantiques,
et les deuxièmes grilles de commande sont décalées, selon la direction perpendiculaire à la face supérieure du support, par rapport aux premières grilles de commande, chacune des deuxièmes grilles de commande étant disposée dans un niveau de grille interposé entre deux autres niveaux de grille comprenant chacun une des premières grilles de commande.

Selon un mode de réalisation particulier, le dispositif comporte en outre plusieurs premières portions diélectriques disposées entre les premières grilles de commande et plusieurs deuxièmes portions diélectriques disposées entre les deuxièmes grilles de commande.

Selon un mode de réalisation particulier, selon une direction perpendiculaire aux faces latérales, chacune des premières grilles de commande comporte une largeur différente de celles des autres premières grilles de commande et chacune des deuxièmes grilles de commande comporte une largeur différente de celles des autres deuxièmes grilles de commande.

Selon un mode de réalisation particulier, une dimension de l'ailette de semi-conducteur perpendiculaire aux première et deuxième faces latérales est telle qu'un seul plan ou deux plans de boîtes quantiques parallèles aux première et deuxième faces latérales sont destinés à être formés dans l'ailette de semi-conducteur.

Selon un mode de réalisation particulier, des hauteurs, selon la direction perpendiculaire à la face supérieure du support, des premières et deuxièmes grilles de commande sont égales les unes aux autres.

Selon un mode de réalisation particulier, dans un plan perpendiculaire à la face supérieure du support et perpendiculaire aux première et deuxième faces latérales, les premières et deuxièmes grilles de commande sont alignées les unes par rapport aux autres, ou les premières grilles de commande sont décalées par rapport aux deuxièmes grilles de commande.

Selon un mode de réalisation particulier, le dispositif comprend plusieurs ensembles distincts de premières et deuxièmes grilles de commande disposés le long d'une longueur de l'ailette de semi-conducteur qui correspond à une dimension parallèle aux première et deuxième faces latérales et à la face supérieure du support.

Il est également proposé un procédé de réalisation d'un dispositif électronique, comportant :
- réalisation d'une ailette de semi-conducteur sur une face supérieure du support, dans laquelle des boîtes quantiques sont destinées à être formées, et comprenant une première face latérale et une deuxième face latérale opposée à la première face latérale ;
- réalisation de plusieurs premières grilles de commande disjointes les unes des autres, disposées du côté de la première face latérale, les unes au-dessus des autres selon une direction perpendiculaire à la face supérieure du support et définissant différents niveaux de grille, configurées pour commander chacune le potentiel électrostatique d'une des boîtes quantiques, la première grille de commande la plus proche du support étant disposée dans un niveau de grille N, et la première grille de commande la plus éloignée du support étant disposée dans un niveau de grille N+Z, avec N correspondant à un nombre entier supérieur ou égal à 1, et Z correspondant à un nombre entier supérieur ou égal à 2 ;
- réalisation d'au moins une deuxième grille de commande disposée du côté de la deuxième face latérale, et configurée pour commander le potentiel électrostatique d'une région de couplage destinée à être formée entre les boîtes quantiques ;
dans lequel ladite au moins une deuxième grille de commande est décalée, selon la direction perpendiculaire à la face supérieure du support, par rapport aux premières grilles de commande et définit un niveau de grille interposé entre deux autres niveaux de grille comprenant chacun une des premières grilles de commande.

Il est également proposé un procédé de réalisation d'un dispositif électronique, comportant :
- réalisation d'une ailette de semi-conducteur sur une face supérieure du support, dans laquelle des boîtes quantiques sont destinées à être formées, et comprenant une première face latérale et une deuxième face latérale opposée à la première face latérale ;
- réalisation de plusieurs premières grilles de commande disjointes les unes des autres, disposées du côté de la première face latérale, les unes au-dessus des autres selon une direction perpendiculaire à la face supérieure du support et définissant différents niveaux de grille, configurées pour commander chacune le potentiel électrostatique d'une des boîtes quantiques, la première grille de commande la plus proche du support étant disposée dans un niveau de grille N, et la première grille de commande la plus éloignée du support étant disposée dans un niveau de grille N+Z, avec N correspondant à un nombre entier supérieur ou égal à 1, et Z correspondant à un nombre entier supérieur ou égal à 2 ;
- réalisation d'au moins une deuxième grille de commande disposée du côté de la deuxième face latérale, et configurée pour commander le potentiel électrostatique d'une région de couplage destinée à être formée entre les boîtes quantiques ;
dans lequel la ou les grilles de commande disposées du côté de la deuxième face latérale sont décalées, selon la direction perpendiculaire à la face supérieure du support, par rapport aux grilles de commande disposées du côté de la première face latérale et définissent un ou plusieurs niveaux de grille chacun interposé entre deux autres niveaux de grille comprenant chacun une des grilles de commande disposées du côté de la première face latérale.

Selon un mode de réalisation particulier, la réalisation de l'ailette de semi-conducteur comporte au moins une gravure du support, et les premières et deuxièmes grilles de commande sont ensuite réalisées sur des parties restantes du support disposées de part et d'autre de l'ailette de semi-conducteur.

Selon un mode de réalisation particulier, la réalisation de l'ailette de semi-conducteur comporte au moins une croissance épitaxiale à partir d'une région du support formant une paroi de fond d'une ouverture formée à travers un empilement de couches disposé sur le support et à partir duquel les premières et deuxièmes grilles de commande sont réalisées.

Selon un mode de réalisation particulier, la réalisation des premières et deuxièmes grilles de commande comporte au moins la mise en oeuvre des étapes suivantes :
- réalisation d'un empilement de couches d'un premier semi-conducteur et de couches d'un deuxième semi-conducteur disposées de manière alternée les unes au-dessus des autres, les premier et deuxième semi-conducteurs étant aptes à être gravés sélectivement l'un par rapport à l'autre ;
- gravure de l'empilement telle qu'au moins deux portions restantes de l'empilement soient chacune disposée contre l'une des première et deuxième parois latérales ;
- retrait sélectif de parties restantes des couches du deuxième semi-conducteur présentes dans les portions restantes de l'empilement ;
- dépôt d'au moins un matériau diélectrique dans des espaces formés par le retrait sélectif des parties restantes des couches du deuxième semi-conducteur, formant des premières portions diélectriques disposées entre les premières grilles de commande et des deuxièmes portions diélectriques disposées entre plusieurs deuxièmes grilles de commande ;
et l'ailette de semi-conducteur est réalisée avant l'empilement.

Selon un mode de réalisation particulier, la réalisation des premières et deuxième grilles de commande comporte au moins la mise en oeuvre des étapes suivantes :
- réalisation d'un empilement de couches d'un matériau électriquement conducteur et de couches d'un matériau diélectrique disposées de manière alternée les unes au-dessus des autres ;
- gravure de l'empilement telle qu'au moins deux portions restantes de l'empilement soient chacune disposée contre l'une des première et deuxième parois latérales ;
et l'empilement de couches est réalisé après l'ailette de semi-conducteur et en mettant en oeuvre des étapes successives de dépôt des couches de matériau électriquement conducteur et des couches de matériau diélectrique et, entre les étapes de dépôt, des étapes de retrait de parties des couches de matériau électriquement conducteur et des couches de matériau diélectrique déposées contre les première et deuxième faces latérales.

Selon un mode de réalisation particulier, la réalisation des premières et deuxièmes grilles de commande comporte au moins la mise en oeuvre des étapes suivantes :
- réalisation d'un empilement de couches d'un matériau électriquement conducteur et de couches d'un matériau diélectrique disposées de manière alternée les unes au-dessus des autres ;
- gravure de l'empilement telle qu'au moins deux portions restantes de l'empilement de couches soient chacune disposée contre l'une des première et deuxième parois latérales ;
et l'ailette de semi-conducteur est réalisée après l'empilement.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
- la figure 1 représente un exemple d'un dispositif électronique selon un mode de réalisation particulier ;
- la figure 2, la figure 3, la figure 4, la figure 5, la figure 6, la figure 7, la figure 8, la figure 9, la figure 10, la figure 11, la figure 12, la figure 13, la figure 14, la figure 15, la figure 16, la figure 17, la figure 18, la figure 19, la figure 20, la figure 21, la figure 22, la figure 23 et la figure 24 représentent des étapes d'un procédé de réalisation d'un dispositif électronique selon un mode de réalisation particulier ;
- la figure 25, la figure 26, la figure 27 et la figure 28 représentent des étapes d'une variante d'un procédé de réalisation d'un dispositif électronique selon un mode de réalisation particulier.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", "latéral", etc., ou à des qualificatifs d'orientation, tels que les termes "horizontal", "vertical", etc., il est fait référence sauf précision contraire à l'orientation des figures. Toutefois, ces termes ne présument pas de la position et de l'orientation réelles du dispositif lors de son utilisation.

Sauf précision contraire, les expressions "environ", "approximativement", "sensiblement", et "de l'ordre de" signifient à 10 % près, de préférence à 5 % près.

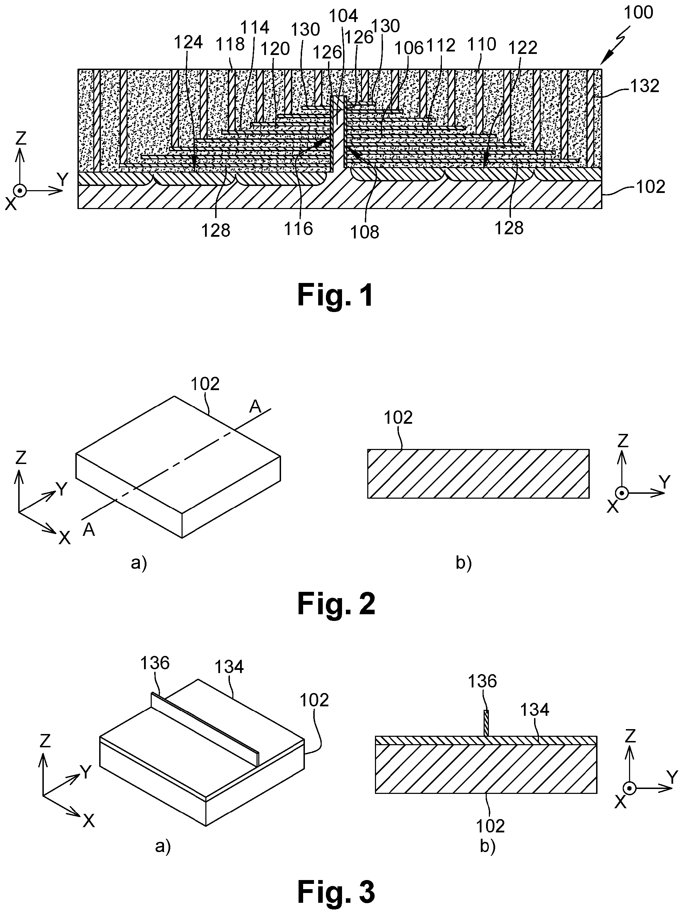

Un exemple d'un dispositif électronique 100 selon un mode de réalisation particulier est décrit ci-dessous en lien avec la figure 1 qui est une vue en coupe du dispositif 100.

Dans l'exemple de réalisation décrit, le dispositif 100 comporte au moins un support 102 sur lequel est disposée au moins une ailette de semi-conducteur 104 (appelée « fin » en anglais). Selon une réalisation particulière du dispositif 100, l'ailette 104 peut correspondre à une portion d'une couche superficielle de semi-conducteur d'un substrat de type semi-conducteur sur isolant, par exemple SOI (« Silicon On Insulator », ou silicium sur isolant). Le support 102, dans ce cas, peut correspondre à l'empilement comprenant la couche diélectrique enterrée disposée sur la couche massive de semi-conducteur du substrat de type semi-conducteur sur isolant. La couche diélectrique enterrée correspond par exemple à une couche de SiO₂ et la couche massive comporte par exemple du silicium.

Par exemple, l'ailette 104 peut comporter du silicium lorsque les qubits destinés à être utilisés dans le dispositif 100 correspondent à des qubits d'électrons. En variante, l'ailette 104 peut comporter par exemple du germanium lorsque les qubits destinés à être utilisés dans le dispositif 100 correspondent à des qubits de trous.

En variante, l'ailette 104 peut ne pas correspondre à une portion d'une couche superficielle d'un substrat de type semi-conducteur sur isolant, et être formée, par exemple par dépôt ou toute autre technique adaptée, sur ou à partir d'un autre type de support 102 correspondant par exemple un substrat bulk ou massif pouvant comporter du semi-conducteur tel qu'un wafer semi-conducteur.

Dans l'exemple de réalisation décrit, une largeur W de l'ailette 104, correspondant à la dimension parallèle à l'axe Y visible sur la figure 1, est par exemple comprise entre 10 nm et 50 nm. Une épaisseur H de l'ailette 104, correspondant à la dimension parallèle à l'axe Z visible sur la figure 1, est par exemple comprise entre 100 nm et 1 µm. La valeur choisie pour cette épaisseur est notamment fonction du nombre de niveaux de grilles du dispositif 100 destinés à être superposés les uns au-dessus des autres, et donc du nombre de boîtes quantiques et des éventuels détecteurs de charges et réservoirs de porteurs destinés à être formés dans l'ailette 104. Enfin, une longueur L de l'ailette 104, correspondant à la dimension parallèle à l'axe X visible sur la figure 1, est par exemple comprise entre 500 nm et 10 µm.

Dans cet exemple de réalisation, le dispositif 100 comporte au moins deux premières grilles de commande 106 disjointes l'une de l'autre, disposées l'une au-dessus de l'autre, et recouvrant chacune une partie d'une première face latérale 108 de l'ailette 104 (face parallèle au plan (X,Z) sur la figure 1). Les premières grilles 106 sont configurées pour commander chacune le potentiel électrostatique d'une des boîtes quantiques destinées à être formées dans l'ailette 104 et être soumises au contrôle électrostatique des premières grilles 106, ce contrôle électrostatique étant obtenu via le potentiel électrique destinée à être appliqué sur chacune de ces premières grilles 106. Chacune des premières grilles 106 comporte au moins une portion électriquement conductrice. Les premières grilles 106 définissent différents niveaux de grille appelés niveaux de premières grilles. La première grille 106 la plus proche du support 102 est disposée dans un niveau de grille N, et la première grille 106 la plus éloignée du support 102 est disposée dans un niveau de grille N+Z, avec N correspondant à un nombre entier supérieur ou égal à 1, et Z correspondant à un nombre entier supérieur ou égal à 2.

Sur l'exemple de la figure 1, le dispositif 100 comporte plus de deux premières grilles 106. Le dispositif 100 comporte toutefois un nombre de premières grilles 106 qui est fonction du nombre de boîtes quantiques destinées à être formées dans l'ailette 104.

Dans une configuration particulière du dispositif 100, chacune des premières grilles 106 peut comporter au moins un matériau électriquement conducteur tel que du silicium monocristallin dopé et/ou du siliciure, ou du polysilicium, ou un empilement de plusieurs matériaux.

Dans une configuration particulière du dispositif 100, chacune des premières grilles 106 comporte une longueur L_{G1} (dimension parallèle à la longueur L de l'ailette 104) par exemple comprise entre 15 nm et 50 nm, et une hauteur H_{G1} (dimension parallèle à la hauteur H de l'ailette 104) par exemple comprise entre 5 nm et 15 nm. La hauteur H_{G1} des premières grilles 106 est fonction notamment du ou des matériaux utilisés pour former ces premières grilles 106 ainsi que de la ou des techniques mises en oeuvre pour former ces premières grilles 106.

Dans l'exemple de réalisation du dispositif 100 décrit et représenté sur la figure 1, chacune des premières grilles 106 comporte, selon un axe perpendiculaire à la première face latérale 108, une largeur W_{G1} différente de celles des autres premières grilles 106. Comme cela est visible sur la figure 1, les valeurs des largeurs W_{G1} des premières grilles 106 sont décroissantes dans le sens allant de la base de l'ailette 104 disposée contre le support 102 jusqu'au sommet de l'ailette 104 (sens parallèle à l'axe Z visible sur la figure 1). Ainsi, l'extrémité de chacune des premières grilles 106 n'est pas disposée en regard de l'une ou plusieurs des autres premières grilles 106 se trouvant au-dessus de cette première grille 106. Ces extrémités peuvent donc servir d'accès électriques à chacune des premières grilles 106. Sur l'exemple de la figure 1, ces accès électriques aux premières grilles 106 sont réalisés par des premiers contacts électriques 110 couplés chacun électriquement à l'extrémité de l'une des premières grilles 106. Les premiers contacts électriques 110 comportent par exemple au moins un matériau métallique tel que du Ti, du TiN ou du W.

Dans une configuration particulière du dispositif 100, chacune des premières grilles 106 est isolée électriquement de la ou des premières grilles 106 voisines (localisées au-dessus et/ou en dessous de la première grille 106 considérée) par des premières portions diélectriques 112 interposées entre elles. Ainsi, deux premières grilles 106 voisines et disposées l'une au-dessus de l'autre sont espacées l'une de l'autre d'une distance égale à l'épaisseur (dimension parallèle à la hauteur H de l'ailette 104) d'une des premières portions diélectriques 112 qui est par exemple comprise entre 5 nm et 15 nm. Les premières portions diélectriques 112 comportent par exemple du SiO₂ ou tout autre matériau diélectrique adapté pour isoler électriquement les premières grilles 106 voisines l'une de l'autre.

Dans l'exemple de réalisation décrit, le dispositif 100 comporte au moins une deuxième grille de commande 114 recouvrant une partie d'une deuxième face latérale 116, opposée à la première face latérale 108, de l'ailette 104. Sur la figure 1, cette deuxième face latérale 116 est parallèle au plan (X,Z). La deuxième grille 114 est configurée pour commander le potentiel électrostatique d'une région de couplage destinée à être formée dans l'ailette 104 entre deux boîtes quantiques et être soumise au contrôle électrostatique de la deuxième grille 114, ce contrôle électrostatique étant obtenu via le potentiel électrique destinée à être appliqué sur la deuxième grille 114. La deuxième grille 114 comporte au moins une portion électriquement conductrice. La deuxième grille 114 définit un niveau de grille appelé niveau de deuxième grille et qui est interposé entre deux autres niveaux de première grille comprenant chacun une des premières grilles 106.

Sur l'exemple de la figure 1, le dispositif 100 comporte plusieurs deuxièmes grilles 114. Le dispositif 100 comporte toutefois un nombre de deuxièmes grilles 114 qui est fonction du nombre de régions de couplage destinées à être contrôlées dans l'ailette 104. Chacune des deuxièmes grilles 114 est disposée dans un niveau de deuxième grille interposé entre deux autres niveaux de première grille comprenant chacun une des premières grilles 106.

Dans une configuration particulière du dispositif 100, chacune des deuxièmes grilles 114 peut comporter au moins un matériau électriquement conducteur tel que du silicium monocristallin dopé et/ou du siliciure, ou du polysilicium, ou un empilement de plusieurs matériaux. Dans une configuration avantageuse, le ou les matériaux des deuxièmes grilles 114 sont similaires à celui ou ceux des premières grilles 106.

Dans une configuration particulière du dispositif 100, chacune des deuxièmes grilles 114 comporte une longueur L_{G2} (dimension parallèle à la longueur L de l'ailette 104) par exemple comprise entre 15 nm et 50 nm et qui est par exemple égale à la longueur L_{G1}. En outre, chacune des deuxièmes grilles 114 peut comporter une hauteur H_{G2} (dimension parallèle à la hauteur H de l'ailette 104) par exemple comprise entre 5 nm et 15 nm et qui est par exemple égale à la hauteur H_{G1}. La hauteur H_{G2} des deuxièmes grilles 114 est fonction notamment du ou des matériaux utilisés pour former ces deuxièmes grilles 114 ainsi que de la ou des techniques mises en oeuvre pour former ces deuxièmes grilles 114.

Dans l'exemple de réalisation décrit, comme pour les premières grilles 106, chacune des deuxièmes grilles 114 comporte, selon un axe perpendiculaire à la deuxième face latérale 116, une largeur W_{G2} différente de celles des autres deuxièmes grilles 114. Comme cela est visible sur la figure 1, les valeurs des largeurs W_{G2} des deuxièmes grilles 114 sont décroissantes dans le sens allant de la base de l'ailette 104 disposée contre le support 102 jusqu'au sommet de l'ailette 104 (sens parallèle à l'axe Z visible sur la figure 1). Ainsi, l'extrémité de chacune des deuxièmes grilles 114 n'est pas disposée en regard de l'une ou plusieurs des autres deuxièmes grilles 114 se trouvant au-dessus de cette deuxième grille 114. Ces extrémités peuvent donc servir d'accès électriques à chacune des deuxièmes grilles 114. Sur l'exemple de la figure 1, ces accès électriques aux deuxièmes grilles 114 sont réalisés par des deuxièmes contacts électriques 118 couplés chacun électriquement à l'extrémité de l'une des deuxièmes grilles 114. Les deuxièmes contacts électriques 118 comportent par exemple au moins un matériau métallique tel que du Ti, du TiN, ou du W, et comportent par exemple le ou les mêmes matériaux que ceux formant les premiers contacts électriques 110.

Dans une configuration particulière du dispositif 100, chacune des deuxième grille 114 est isolée électriquement de la ou des deuxièmes grilles 114 voisines (localisées au-dessus et/ou en dessous de la deuxième grille 114 considérée) par des deuxièmes portions diélectriques 120 interposées entre elles. Ainsi, deux deuxièmes grilles 114 voisines et disposées l'une au-dessus de l'autre sont espacées l'une de l'autre d'une distance égale à l'épaisseur (dimension parallèle à la hauteur H de l'ailette 104) d'une des deuxièmes portions diélectriques 120 qui est par exemple comprise entre 5 nm et 15 nm et qui est par exemple égale à l'épaisseur de l'une des premières portions diélectriques 112. Les deuxièmes portions diélectriques 120 comportent par exemple du SiO₂ ou tout autre matériau diélectrique adapté pour isoler électriquement les deuxièmes grilles 114 voisines l'une de l'autre. Les deuxièmes portions diélectriques 120 comportent avantageusement le même ou les mêmes matériaux diélectriques que ceux formant les premières portions diélectriques 112.

Dans le dispositif 100, les premières grilles 106 ne sont pas alignées, dans un plan parallèle à leur largeur W_{G1} et à leur longueur L_{G1} (plan parallèle au plan (X, Y) sur la figure 1), avec les deuxièmes grilles 114, c'est-à-dire ne sont pas disposées entièrement, ou totalement, en regard des premières grilles 106. Autrement dit, au moins une partie des projections orthogonales des parties de la deuxième face latérale 116 recouvertes par les deuxièmes grilles 114 sur la première face latérale 108 sont disposées entre les parties de la première face latérale 108 recouvertes par les premières grilles 106. De manière avantageuse, les premières et deuxièmes grilles 106, 114 sont disposées alternativement dans des niveaux de grille différents le long de la dimension parallèle à l'épaisseur H de l'ailette 104, c'est-à-dire le long de l'axe Z. Autrement dit, les niveaux de première grille et les niveaux de deuxième grille sont disposés alternativement le long de la dimension parallèle à l'épaisseur H de l'ailette 104.

Dans l'exemple de réalisation décrit, ce décalage entre les premières grilles 106 et les deuxièmes grilles 114 est la conséquence du fait qu'une première partie 122 d'une face supérieure du support 102 (sur laquelle sont disposées les premières grilles 106) est disposée dans un plan différent de celui dans lequel est disposée une deuxième partie 124 de la face supérieure du support 102 (sur laquelle sont disposées les deuxièmes grilles 114). La différence de hauteur (dimension parallèle à l'axe Z) entre les première et deuxième parties 122, 124 de la face supérieure du support 102 est par exemple égale à l'épaisseur de l'une des premières et deuxièmes portions diélectriques 112, 120 et qui correspond par exemple à l'épaisseur H_{G1}, H_{G2} de l'une des premières ou deuxièmes grilles 106, 114. Sur l'exemple de réalisation représenté sur la figure 1, l'épaisseur de la partie du support 102 incluant la première partie 122 de sa face supérieure est plus importante que celle incluant la deuxième partie 124 de sa face supérieure. En variante, il est possible que l'épaisseur de la partie du support 102 incluant la première partie 122 de sa face supérieure soit plus petite que celle incluant la deuxième partie 124 de sa face supérieure.

En variante, il est possible que le décalage entre les premières grilles 106 et les deuxièmes grilles 114, parallèlement à leur hauteur, soit dû non pas à une différence de hauteur entre les première et deuxième parties 122, 124 de la face supérieure du support 102, mais à une portion de matériau supplémentaire présente uniquement sur l'une de ces première et deuxième parties 122, 124 de la face supérieure du support 102 et sur laquelle les premières grilles 106 ou les deuxièmes grilles 114 sont réalisées.

Dans l'exemple de réalisation représenté sur la figure 1, les projections orthogonales des parties de la deuxième face latérale 116 recouvertes par les deuxièmes grilles 114 sur la première face latérale 108 sont disposées entre les parties de la première face latérale 108 recouvertes par les premières grilles 106, sans recouvrement entre ces parties projetées de la deuxième face latérale 116 et celles de la première face latérale 108 recouvertes par les premières grilles 106. En variante, il est possible d'avoir un recouvrement partiel des parties projetées de la deuxième face latérale 116 et celles de la première face latérale 108 recouvertes par les premières grilles 106. Par exemple, ce recouvrement partiel peut être tel qu'au maximum, la moitié de la surface de chacune des projections orthogonales des parties de la deuxième face latérale 116 recouvertes par les deuxièmes grilles 114 sur la première face latérale 108 recouvre l'une des parties de la première face latérale 108 recouvertes par les premières grilles 106.

Dans l'exemple de réalisation du dispositif 100 décrit, les faces latérales 108, 116 de l'ailette 104 sont recouvertes d'une couche diélectrique 126 destinée à servir notamment d'oxyde de grille pour les premières grilles 106 et les deuxièmes grilles 114. La couche diélectrique 126 comporte par exemple du SiO₂ et/ou de l'Al₂O₃ et/ou du HfO₂. L'épaisseur de la couche diélectrique 126 est par exemple comprise entre 2 nm et 20 nm.

Dans la suite de la description, il est fait référence à plusieurs deuxièmes grilles de commande 114 du dispositif 100. Néanmoins, les différentes caractéristiques décrites en lien avec les deuxièmes grilles de commande 114 s'appliqueraient aussi à la seule deuxième grille de commande 114 du dispositif 100 si le dispositif 100 ne comportait qu'une seule deuxième grille de commande 114.

Lors du fonctionnement du dispositif 100, un potentiel électrique, par exemple compris entre 50 mV et 150 mV, peut être appliqué sur les premières grilles 106 pour créer les boîtes quantiques dans l'ailette 104. Les deuxièmes grilles 116 sont utilisées pour coupler ou découpler les qubits des boîtes quantiques 114 selon les besoins, en appliquant sur celles-ci des potentiels électriques, par exemple compris entre - 3 V et + 3 V, engendrant un effet attractif ou répulsif, de valeur positive ou négative.

Le dispositif 100 peut comporter en outre plusieurs troisièmes grilles 128 disjointes les unes des autres, disposées sous les premières et deuxièmes grilles 106, 114 et recouvrant chacune une partie de l'une des première et deuxième faces latérales 108, 116. Dans une configuration particulière, il est possible d'avoir plusieurs troisièmes grilles 128 disjointes, superposées les unes au-dessus des autres et disposées sous les premières grilles 106, ainsi que d'autres troisièmes grilles 128 disjointes, superposées les unes au-dessus des autres et disposées sous les deuxièmes grilles 114. Les troisièmes grilles 128 comportent par exemple une longueur (dimension parallèle à la longueur (dimension parallèle à la longueur L de l'ailette 104) et une hauteur (dimension parallèle à la hauteur H de l'ailette 104) par exemple similaire à celles des premières grilles 106 et/ou des deuxièmes grilles 114. Le ou les matériaux de ces troisièmes grilles 128 sont par exemple similaire à ceux des premières grilles 106 et/ou des deuxièmes grilles 114. Les troisièmes grilles 128 sont ici disposées dans des niveaux de grille inférieurs à, ou sous, ceux comprenant les premières et deuxièmes grilles 106, 114.

Le dispositif 100 peut comporter en outre plusieurs quatrièmes grilles 130 disjointes les unes des autres, disposées au-dessus des premières et deuxièmes grilles 106, 114 et recouvrant chacune une partie de l'une des premières et deuxièmes faces latérales 108, 116. Dans une configuration particulière, il est possible d'avoir plusieurs quatrièmes grilles 130 disjointes, superposées les unes au-dessus des autres et disposées au-dessus des premières grilles 106, ainsi que d'autres quatrièmes grilles 130 disjointes, superposées les unes au-dessus des autres et disposées au-dessus des deuxièmes grilles 114. Les quatrièmes grilles 130 comportent par exemple une longueur (dimension parallèle à la longueur (dimension parallèle à la longueur L de l'ailette 104) et une hauteur (dimension parallèle à la hauteur H de l'ailette 104) par exemple similaire à celles des premières grilles 106 et/ou des deuxièmes grilles 114. Le ou les matériaux de ces quatrièmes grilles 130 sont par exemple similaire à ceux des premières grilles 106 et/ou des deuxièmes grilles 114. Les quatrièmes grilles 130 sont ici disposées dans des niveaux de grille supérieurs à, ou au-dessus de, ceux comprenant les premières et deuxièmes grilles 106, 114.

Les troisièmes et quatrièmes grilles 128, 130 disposées du même côté que les premières grilles 106, c'est-à-dire celles recouvrant chacune une partie de la première face latérale 108, peuvent servir à contrôler les potentiels électrostatiques de détecteurs de charge formés dans des parties de l'ailette 104 entre lesquelles les boîtes quantiques sont destinées à être formées et/ou servir d'amenées de courant depuis des réservoirs de porteurs jusqu'aux détecteurs de charges et/ou boîtes quantiques.

Les troisièmes et quatrièmes grilles 128, 130 disposées du même côté que les deuxièmes grilles 114, c'est-à-dire celles recouvrant chacune une partie de la deuxième face latérale 116, peuvent servir à contrôler les régions de couplage entre les détecteurs de charge et les boîtes quantiques et/ou les régions de couplage entre les amenées de courant et les détecteurs de charges ou entre les amenées de courant et les boîtes quantiques.

Le décalage de hauteur précédemment décrit entre les premières grilles 106 et les deuxièmes grilles 114 peut se retrouver également entre les troisièmes grilles 128 se trouvant de part et d'autre de l'ailette 104 et également entre les quatrièmes grilles 130 se trouvant de part et d'autre de l'ailette 104. En outre, lorsque le dispositif 100 comporte les troisièmes grilles 128 et les quatrièmes grilles 130, des premières portions diélectriques 112 et des deuxièmes portions diélectriques 120 sont également disposées entre les troisièmes grilles 128 voisines, entre les troisièmes grilles 128 et les autres grilles voisines de celles-ci, entre les quatrièmes grilles 130 voisines, et entre les quatrièmes grilles 130 et les autres grilles voisines de celles-ci. Les contacts électriques des troisièmes et quatrièmes grilles 128, 130 peuvent également être assurés par des contacts électriques similaires aux premiers et deuxièmes contacts électriques 110, 118.

Dans l'exemple de réalisation décrit, le dispositif 100 comporte également un matériau diélectrique d'encapsulation 132 recouvrant l'empilement de grilles 106, 114, 128, 130, l'ailette 104 et les parties du support 102 non recouvertes par les grilles. En présence d'un tel matériau diélectrique d'encapsulation 132, les contacts électriques 110, 118 peuvent être réalisés à travers ce matériau diélectrique d'encapsulation 132. Ce matériau diélectrique d'encapsulation 132 correspond par exemple à du SiO₂.

Ce motif particulier des grilles 106, 114 peut être répété, par exemple de manière périodique, formant ainsi plusieurs ensembles distincts de premières et deuxièmes grilles de commandes 106, 114 disposés le long de la longueur de l'ailette 104 (dimension parallèle à l'axe X), multipliant ainsi le nombre de qubits pouvant être formés dans l'ailette 104.

Dans les exemples précédemment décrits, les premières grilles 106 et les deuxièmes grilles 114 sont alignées les unes avec les autres, en considérant un plan parallèle au plan (Y, Z), c'est-à-dire un plan qui soit à la fois perpendiculaire à la face supérieure du support 102 et aux première et deuxième face latérales 108, 116 de l'ailette 104. En variante, il est possible d'avoir un décalage, le long de l'axe X, des premières grilles 106 par rapport aux deuxièmes grilles 114.

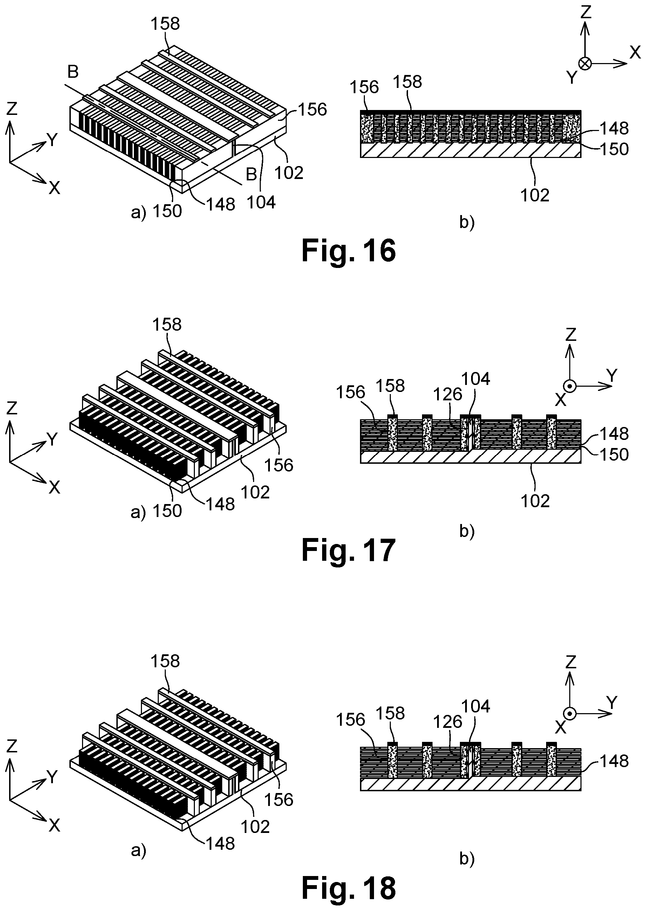

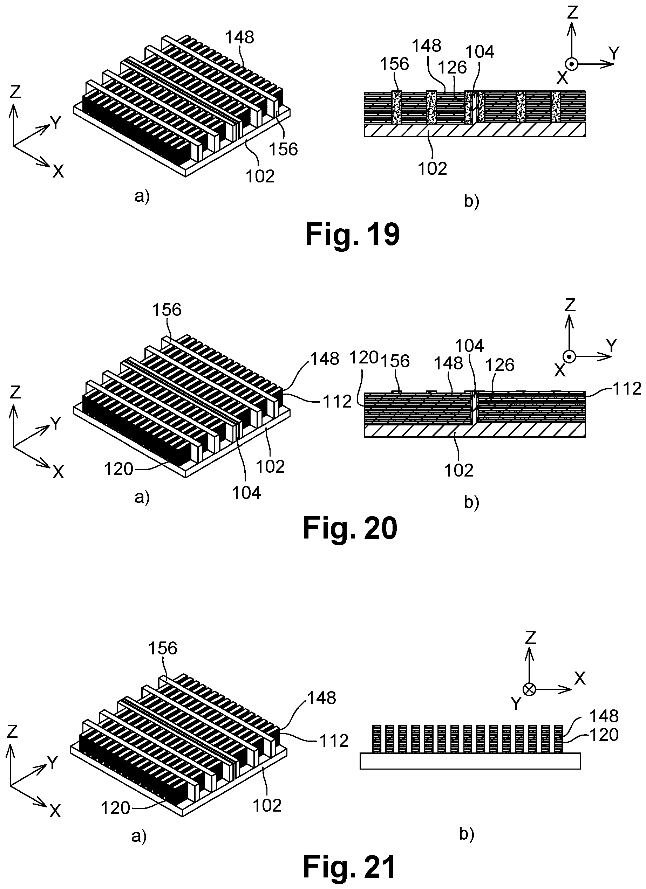

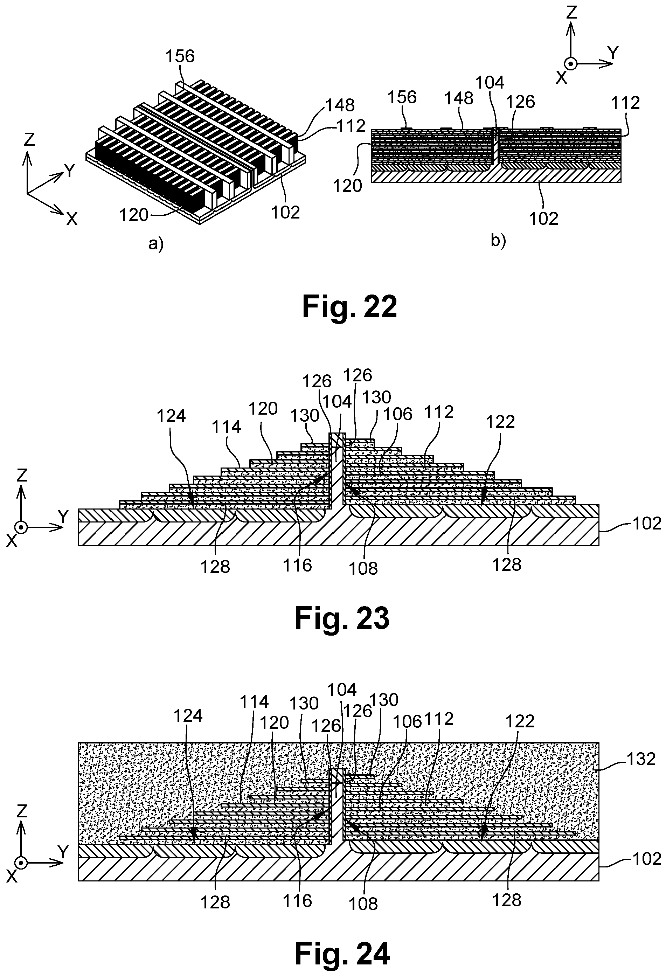

Un exemple d'un procédé de réalisation du dispositif électronique 100 est décrit ci-dessous en lien avec les figures 2 à 24. Sur chacune des figures 2 à 22, la vue a) correspond à une vue en perspective de la structure réalisée, et la vue b) correspond à une vue en coupe de la structure réalisée, cette vue en coupe étant prise selon un axe (AA) pour les figures 2 à 15, 17 à 20 et 22, et selon un axe (BB) pour les figures 16 et 21. Les figures 23 et 24 correspondent à des vues en coupe prises selon l'axe AA.

Dans cet exemple, l'ailette 104 est tout d'abord réalisée. Dans l'exemple décrit, l'ailette 104 est réalisée à partir du support 102 qui correspond à un substrat massif de semi-conducteur, par exemple du silicium ou du germanium (voir figure 2).

Pour réaliser l'ailette 104, une couche de masque dur 134, comprenant par exemple du SiN, est déposée sur le support 102 (voir figure 3). Cette couche 134 est ensuite gravée selon le motif souhaité pour l'ailette 104. Sur l'exemple de la figure 3, une résine de lithographie 136 est formée sur la couche 134 selon le motif souhaité pour l'ailette 104.

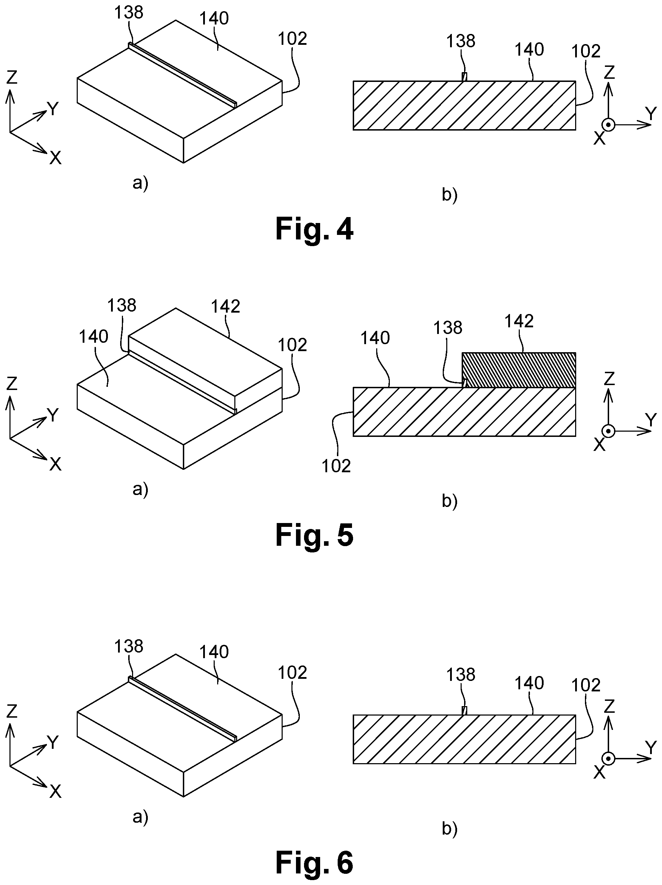

Le masque dur obtenu à l'issue de cette gravure est désigné par la référence 138 et visible sur la figure 4. De manière optionnelle, une oxydation de la surface de semi-conducteur du support 102 peut être mise en oeuvre. Sur l'exemple de la figure 4, cette oxydation forme une couche 140 d'oxyde de semi-conducteur, par exemple du SiO₂ lorsque le support 102 comporte du silicium.

Le support 102 est ensuite gravé de manière à ce que la première partie 122 de la face supérieure du support 102 soit disposée dans un plan différent de celui dans lequel est disposée la deuxième partie 124 de la face supérieure du support 102. Pour cela, une lithographie est mise en oeuvre en utilisant une résine 142 masquant le masque dur 138 et la partie du support 102 (et donc également de la couche 140 si une oxydation du support 102 a été préalablement mise en oeuvre) destinée à être plus épaisse que l'autre, c'est-à-dire celle destinée à inclure la première partie 122 de la face supérieure du support 102 (voir figure 5).

La partie du support 102 (et éventuellement de la couche 140 si celle-ci est présente) non recouverte par la résine 142 est ensuite gravée partiellement afin d'obtenir la différence de hauteur souhaitée ultérieurement entre les première et deuxième parties 122, 124 de la face supérieure du support 102. La résine 142 est ensuite supprimée (voir figure 6).

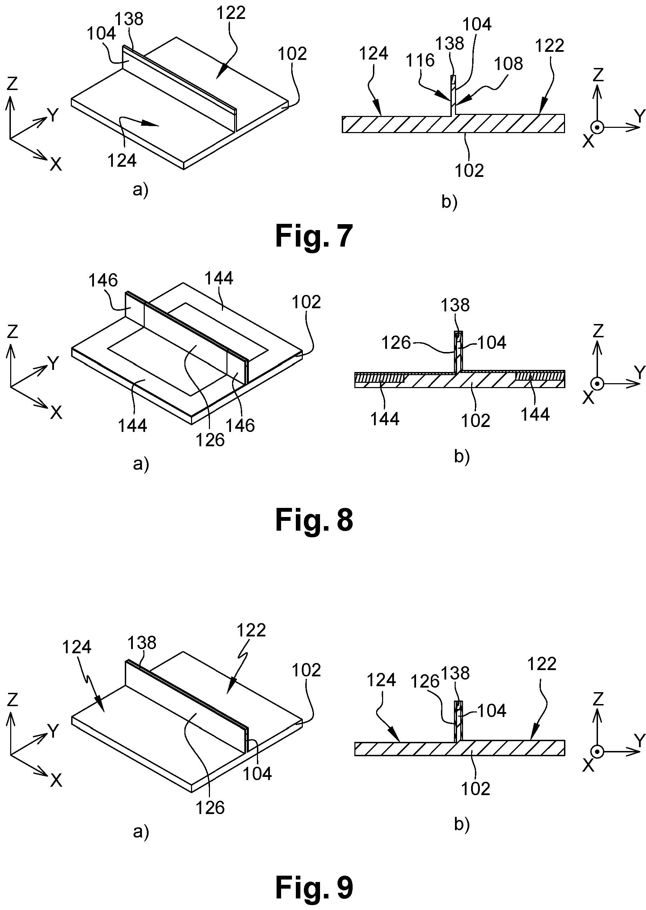

La réalisation de l'ailette 104 est ensuite achevée en mettant en oeuvre une gravure du support 102 (et éventuellement de la partie restante de la couche 140 préalablement recouverte par la résine 142 si celle-ci est présente). La partie du support 102 recouverte par le masque dur 138 est protégée de cette gravure et forme l'ailette 104. Cette gravure est stoppée lorsque la hauteur H de l'ailette 104 souhaitée est obtenue. Cette gravure forme également les première et deuxième parties 122, 124 de la face supérieure du support 102 sur laquelle les premières et deuxièmes grilles 106, 114 vont être réalisées. La structure obtenue à ce stade du procédé est représentée sur la figure 7.

En variante, l'ailette 104 peut être réalisée par gravure de la couche superficielle d'un substrat SOI. D'autres variantes peuvent également être mises en oeuvre pour former l'ailette 104 sur le support 102.

Dans l'exemple décrit, des réservoirs de porteurs sont ensuite réalisés, par exemple en masquant les régions du support 102 et de l'ailette 104 dans lesquelles les réservoirs de porteurs ne sont pas réalisés et en mettant en oeuvre une implantation de dopants dans les régions non masquées. Sur la figure 8, les régions de la face supérieure du support 102 à travers lesquelles les dopants sont implantés sont désignés par la référence 144, et les réservoirs de porteurs réalisés correspondent aux régions de l'ailette 104 dans lesquelles les dopants sont implantés, ces réservoirs étant désignés par la référence 146. Dans l'exemple décrit, ces réservoirs de porteurs 146 sont réalisés dans les extrémités de l'ailette 104. Par simplification, les régions dopées 144 du support 102 et les réservoirs de porteurs 146 formés dans l'ailette 104 ne sont plus représentées sur les figures 9 et suivantes.

La couche diélectrique 126 est ensuite réalisée. Le matériau diélectrique peut être formé sur l'ensemble de la structure réalisée, sous la forme d'un dépôt conforme (épaisseur sensiblement constante sur l'ensemble des parois contre lesquelles le matériau diélectrique est déposé) comme cela est visible sur la figure 8. En variante, il est possible de former cette couche diélectrique 126 en mettant en oeuvre une oxydation thermique du semi-conducteur de l'ailette 104 et des autres parties accessibles du support 102, notamment les parties 122, 124 de la face supérieure du support 102. Lorsqu'une telle oxydation thermique est mise en oeuvre, la couche diélectrique n'est pas formée contre les parois du masque dur 138. La mise en oeuvre d'une telle oxydation thermique avec un support 102 et une ailette 104 comprenant du silicium forme une couche diélectrique 126 comprenant du SiO₂.

Les parties de la couche diélectrique 126 qui ne recouvrent pas les parois latérales 108, 116 de l'ailette 104 sont ensuite supprimées, en particulier les parties de la couche diélectrique 126 localisées sur les parties 122, 124 de la face supérieure du support 102 et éventuellement la partie de la couche diélectrique 126 localisée sur le sommet de l'ailette 104 (voir figure 9). La suppression de ces parties de la couche diélectrique 126 est par exemple obtenue en mettant en oeuvre une gravure anisotrope de la couche diélectrique 126.

Les premières et deuxièmes grilles 106, 114 sont ensuite réalisées telles que chacune recouvre une partie de l'une des faces latérales 108, 116 de l'ailette 104. Pour réaliser ces grilles, les étapes suivantes sont par exemple mises en oeuvre.

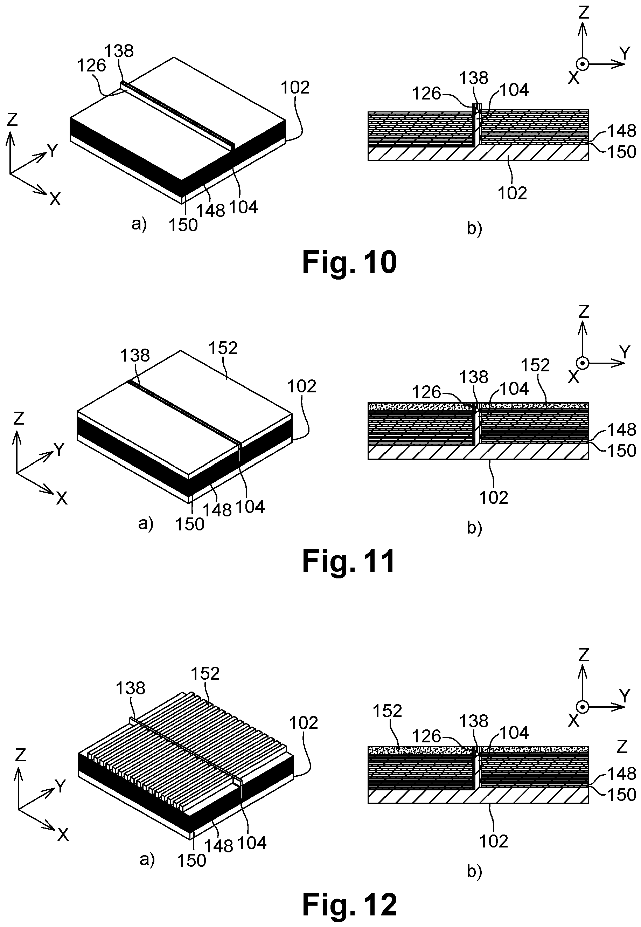

Un empilement de couches d'un premier semi-conducteur 148 et de couches d'un deuxième semi-conducteur 150 disposées de manière alternée les unes au-dessus des autres est réalisé sur les parties 122, 124 de la face supérieure du support 102, c'est-à-dire de part et d'autre de l'ailette 104 et contre la couche diélectrique 126 formée contre les faces latérales 108, 116 de l'ailette 104 (voir figure 10). Les premier et deuxième semi-conducteurs sont choisis tels qu'ils soient aptes à être gravés sélectivement l'un par rapport à l'autre. A titre d'exemple, l'épaisseur de chacune des couches 148, 150 peut être comprise entre 5 nm et 15 nm. Un tel empilement de couches 148, 150 peut être réalisé en mettant en oeuvre des étapes successives d'épitaxie. Selon un exemple de réalisation avantageux, les couches 148 peuvent comporter du silicium et les couches 150 peuvent comporter du SiGe.

L'empilement réalisé est ensuite gravé selon la géométrie souhaitée pour les premières et deuxièmes grilles 106, 114.

Pour cela, une couche de masque dur 152 est déposée sur la structure réalisée, c'est-à-dire sur l'empilement de couches 148, 150 et sur le masque dur 138. Une planarisation mécano-chimique, ou CMP, est ensuite mise en oeuvre avec arrêt sur le masque dur 138 (voir figure 11).

Une lithographie est ensuite mise en oeuvre de façon à transférer le motif souhaité des premières et deuxièmes grilles 106, 114 dans la couche de masque dur 152, puis la couche de masque dur 152 est gravée selon ce motif, les parties restantes de la couche de masque dur 152 recouvrant les portions de l'empilement de couches 148, 150 destinées à la réalisation des premières et deuxièmes grilles 106, 114. Comme cela est visible sur la figure 12, les parties restantes de la couche de masque dur 152 disposées du côté de la première face latérale 108 de l'ailette 104 et définissant le motif des premières grilles 106 sont disposées en regard de celles disposées du côté de la deuxième face latérale 116 de l'ailette 104 et qui définissent le motif des deuxièmes grilles 114.

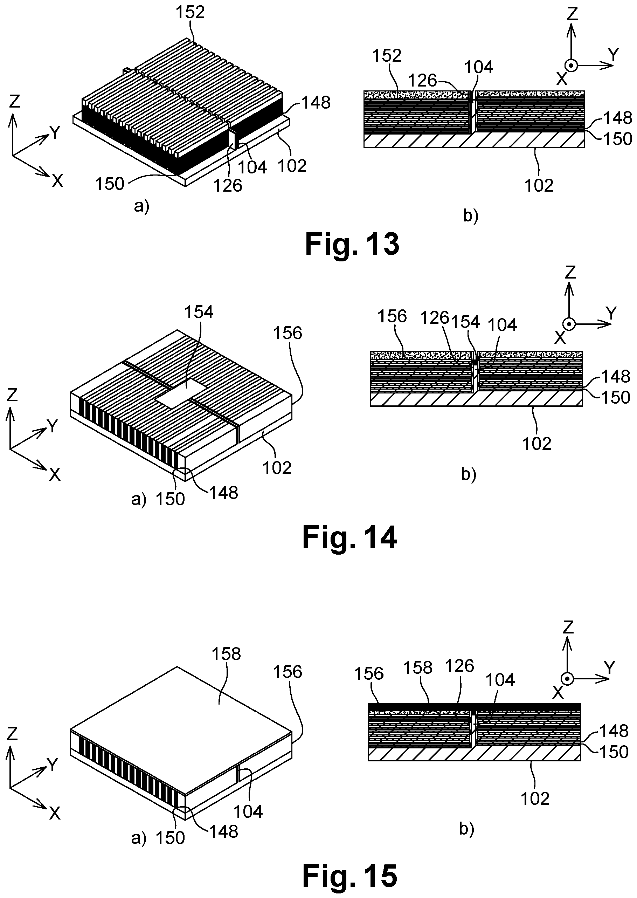

L'empilement de couches est ensuite gravé selon le motif défini par les parties restantes de la couche de masque dur 152, cette gravure étant stoppée lorsque le support 102 est atteint. Le masque dur 138 est également supprimé, par exemple par gravure (voir figure 13).

De manière optionnelle, une étape d'implantation peut être mise en oeuvre afin de former un ou plusieurs autres réservoirs de porteurs 154 dans une partie supérieure de l'ailette 104. Selon un premier exemple, un réservoir de porteurs 154 peut être réalisé dans une partie supérieure et centrale de l'ailette 104, comme représenté sur la figure 14. Selon un deuxième exemple, plusieurs réservoirs de porteurs 154 distincts peuvent être réalisés dans une partie supérieure de l'ailette 104, et alignés selon une direction parallèle à la longueur de l'ailette 104 (parallèle à l'axe X). Cet ou ces autres réservoirs de porteurs 154 peuvent être obtenus en mettant en oeuvre une étape de masquage puis une étape d'implantation de dopants, comme pour la réalisation des réservoirs de porteurs 146 précédemment décrite. Par simplification, cet autre réservoir de porteurs 154 n'est représenté que sur la figure 14 et non sur les figures suivantes.

Une couche d'encapsulation 156 comprenant par exemple de l'oxyde tel que du SiO₂ est ensuite déposée de manière à encapsuler les portions non gravées de l'empilement de couches 148, 150. Le matériau de cette couche d'encapsulation est notamment déposé autour et entre les portions non gravées de l'empilement. Une CMP peut ensuite être mise en oeuvre jusqu'à atteindre l'épaisseur souhaitée pour la couche d'encapsulation 156 (voir figure 14).

Dans l'exemple décrit, les parties restantes de la couche de masque dur 152 peuvent être conservées lors du dépôt de la couche d'encapsulation 156, par exemple lorsque les matériaux de la couche de masque dur 152 et de la couche d'encapsulation 156 sont identiques. En variante, et en particulier lorsque les matériaux de la couche de masque dur 152 et de la couche d'encapsulation 156 ne sont pas identiques, les parties restantes de la couche de masque dur 152 peuvent être retirées avant le dépôt de la couche d'encapsulation 156.

Afin de faciliter le retrait des couches du deuxième semi-conducteur 150, une structure de maintien mécanique peut être réalisée sur l'empilement de couches.

Pour réaliser cette structure, une autre couche de masque dur 158 est déposée sur la structure réalisée à ce stade (voir figure 15). Une lithographie est ensuite mise en oeuvre et la couche de masque dur 158 est gravée selon le motif défini par cette lithographie (voir figure 16).

La couche d'encapsulation 156 est ensuite gravée selon le motif de la couche de masque dur 158 (voir figure 17).

Les couches du deuxième semi-conducteur 150 sont ensuite supprimées, par exemple par gravure sélective vis-à-vis des autres matériaux présents, en particulier vis-à-vis des couches du premier semi-conducteur 148 (voir figure 18). La présence des portions restantes de la couche d'encapsulation 156 permet d'assurer le maintien mécanique des couches du premier semi-conducteur 148.

La couche de masque dur 158 est ensuite retirée (voir figure 19).

Les vues b) des figures 17 à 19 sont telles que l'axe de coupe AA ne passe pas par les portions restantes des couches des premier et deuxième semi-conducteurs 148, 150.

Un dépôt conforme de matériau diélectrique sur l'ensemble de la structure est ensuite mis en oeuvre, formant notamment les premières portions diélectriques 112 et les deuxièmes portions diélectriques 120 entre les couches du premier semi-conducteur 148 (voir figure 20). Le matériau diélectrique déposé correspond par exemple à du SiO₂.

Une gravure partielle du matériau diélectrique déposé est ensuite mise en oeuvre, notamment pour retirer les portions de ce matériau diélectrique recouvrant les faces supérieures et les flancs latéraux des empilements comprenant les parties de la couche du premier semi-conducteur 148 et les premières et deuxièmes portions diélectriques 112, 120. La structure obtenue à ce stade est représentée sur la figure 21.

Une siliciuration des couches du premier semi-conducteur 148 peut ensuite être mise en oeuvre (voir figure 22) .

Une gravure des couches du premier semi-conducteur 148, des premières portions diélectriques 112 et des deuxièmes portions diélectriques 120 peut ensuite être mise en oeuvre afin que l'une de leurs extrémités soit dévoilée et forment des accès électriques à chacun de ces éléments. Cette gravure achève la réalisation des premières et deuxièmes 106, 114, ainsi que celle des troisièmes et quatrièmes grilles 128, 130 (voir figure 23).

Le matériau diélectrique d'encapsulation 132 peut ensuite être déposé de manière à recouvrir l'ensemble de la structure réalisée (voir figure 24).

Le dispositif 100 peut ensuite être achevé en réalisant les premiers et deuxièmes contacts électriques 110, 118 ainsi que ceux reliés électriquement aux troisièmes et quatrièmes grilles 128, 130, ces contacts pouvant être réalisés à travers le matériau diélectrique d'encapsulation 132, par exemple en gravant le matériau diélectrique d'encapsulation 132 puis en remplissant les trous gravés dans le matériau diélectrique d'encapsulation 132 par un ou plusieurs matériaux électriquement conducteurs. Le dispositif 100 obtenu correspond à l'issue de ce procédé correspond à celui précédemment décrit en lien avec la figure 1.

Dans le procédé décrit ci-dessus, les différentes grilles 106, 114, 128, 130 sont réalisées en formant tout d'abord un empilement de couches alternées pouvant être gravées sélectivement les unes par rapport aux autres (par exemple un empilement de type Si/SiGe) puis en gravant sélectivement les couches de l'un des deux matériaux et en remplissant les espaces obtenus par un matériau diélectrique pour former les premières et deuxièmes portions diélectriques 112, 120.

En variante, il est possible de réaliser directement un empilement comprenant alternativement des couches de matériau(x) électriquement conducteur(s), par exemple du polysilicium dopé *in-situ* (amorphe ou non) et/ou un ou plusieurs matériaux métalliques, et des couches de matériau diélectrique, par exemple du SiO₂. Dans ce cas, il n'est pas nécessaire de réaliser la structure de maintien mécanique ni les différentes étapes précédemment décrites permettant de remplacer les couches du deuxième semi-conducteur 150 par les premières et deuxièmes portions diélectriques 112, 120. Dans cette variante, il convient toutefois de s'assurer que les dépôts successifs mis en oeuvre ne laissent pas de couches résiduelles contre les faces latérales 108, 116 de l'ailette 104. Si les dépôts mis en oeuvre laissent de telles couches résiduelles sur les flancs de l'ailette 104, des étapes de gravure de ces couches résiduelles peuvent être mises en oeuvre entre les étapes de dépôt. Dans ce cas, il est possible de déposer, après chaque dépôt de couches de l'empilement, une couche planarisante type SOC, puis de graver la couche résiduelle présente sur les flancs de l'ailette 104 et non recouverte par la couche planarisante. Alternativement à l'utilisation d'une couche planarisante, il possible de mettre en oeuvre une CMP puis de réaliser un retrait partiel du matériau déposé pour retirer la couche résiduelle.

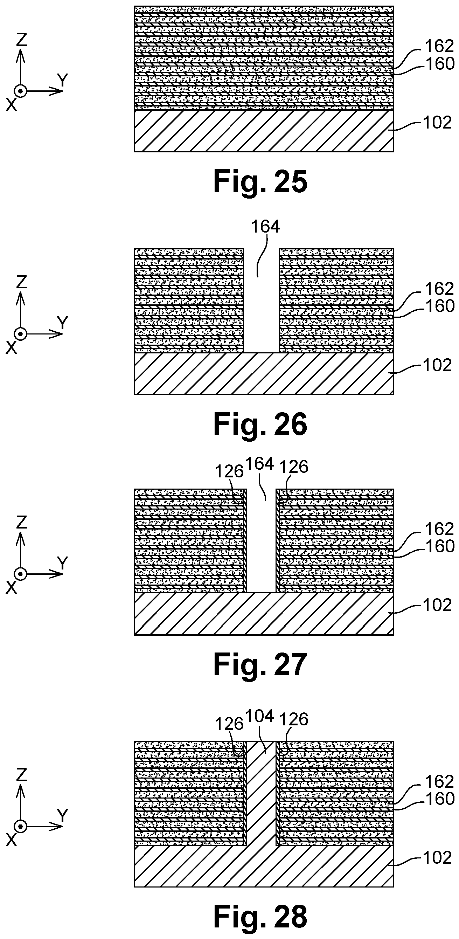

Selon une autre alternative, afin de s'affranchir des problèmes liés à la présence éventuelle de couches résiduelles contre les parois latérales de l'ailette 104, il est possible de réaliser l'empilement de couches de matériau électriquement conducteur et de couches de matériau diélectrique préalablement à la réalisation de l'ailette 104. La figure 25 représente un tel empilement dans lequel la référence 160 désigne les couches de matériau électriquement conducteur et la référence 162 désigne les couches de matériau diélectrique.

Une gravure est ensuite mise en oeuvre à travers cet empilement de couches 160, 162, afin de former une ouverture 164 pour l'ailette 104 (figure 26). L'ouverture gravée correspond par exemple à une tranchée.

La couche diélectrique 126 peut ensuite être déposée contre les flancs de l'ouverture 164 (voir figure 27).

L'ailette 104 peut ensuite être réalisée dans l'espace restant de l'ouverture 164, par exemple en mettant en oeuvre une épitaxie depuis la paroi de fond de l'ouverture 164 formée par le support 102 (voir figure 28).

En variante des différents exemples de réalisation précédemment décrits, le dispositif 100 peut comporter une ou plusieurs cinquièmes grilles de commande disposées au-dessus des premières grilles 106, et une ou plusieurs sixièmes grilles de commande, disposées au-dessus des deuxièmes grilles 114. En présence de plusieurs cinquièmes grilles, ces cinquièmes grilles sont disjointes les unes des autres et peuvent être superposées les unes au-dessus des autres. En présence de plusieurs sixièmes grilles, ces sixièmes grilles sont disjointes les unes des autres et peuvent être superposées les unes au-dessus des autres.

Dans cette variante, la cinquième grille ou chacune des cinquièmes grilles recouvre une partie de la première face latérale 108. La sixième grille ou chacun des sixièmes grilles recouvre une partie de la deuxième face latérale 116.

Les cinquièmes et sixièmes grilles comportent par exemple chacune une longueur (dimension parallèle à la longueur L de l'ailette 104) et une hauteur (dimension parallèle à la hauteur H de l'ailette 104) par exemple similaire à celles des premières grilles 106 et/ou des deuxièmes grilles 114. Le ou les matériaux de ces cinquièmes et sixièmes grilles sont par exemple similaire à ceux des premières grilles 106 et/ou des deuxièmes grilles 114.

Dans cette variante, les fonctions des cinquièmes et sixièmes grilles sont inversées par rapport à celles des premières et deuxièmes grilles 106, 114. Ainsi, les cinquièmes grilles sont configurées pour contrôler des barrières tunnel, c'est-à-dire commander le potentiel électrostatique de régions de couplage destinées à être formées entre des boîtes quantiques, et les sixièmes grilles sont configurées pour contrôler le potentiel électrostatique de boîtes quantiques. Chacun des cinquièmes grille de commande est donc disposée dans un niveau de grille interposé entre deux autres niveaux de grille comprenant chacun une des sixièmes grilles de commande.

En présence de telles cinquièmes et sixièmes grilles, il est donc possible d'avoir, de chaque côté de l'ailette de semi-conducteur 104, c'est-à-dire du côté de chacune des première et deuxième faces latérales 108, 116, des grilles contrôlant le potentiel de boîtes quantiques et des grilles contrôlant le potentiel des régions de couplage.

Dans les différents exemples de réalisation et variantes du dispositif 100 décrit, la disposition des premières et deuxièmes grilles 106, 114 sous la forme d'un empilement vertical avec un décalage entre les premières et deuxièmes grilles 106, 114 permet de réduire sensiblement la valeur du pitch atteignable entre les grilles de commande des boîtes quantiques, et ainsi obtenir, dans l'ailette de semi-conducteur, un très forte densité de boîtes quantiques tout en permettant une bonne compensation de l'impact des défauts chargés électriquement présents dans les matériaux du dispositif 100.

Dans les différents exemples de réalisation et variantes du dispositif 100 précédemment décrits, une dimension de l'ailette de semi-conducteur 104 perpendiculaire aux première et deuxième faces latérales 108, 116 (dimension parallèle à l'axe Y sur les différentes figures) est telle qu'un seul plan ou deux plans de boîtes quantiques parallèles aux première et deuxième faces latérales 108, 116 (c'est-à-dire parallèles au plan (X,Y)) sont destinés à être formés dans l'ailette de semi-conducteur 104.

Divers exemples de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications données ci-dessus. Par exemple, la nature (humide, sèche, etc.) de chacune des gravures mises en oeuvre peut être choisie en fonction notamment du ou des matériaux à graver.

## Revendications

1. Dispositif électronique (100) comprenant :
- un support (102) ;
- une ailette de semi-conducteur (104) disposée sur une face supérieure du support (102), dans laquelle des boîtes quantiques sont destinées à être formées, et comprenant une première face latérale (108) et une deuxième face latérale (116) opposée à la première face latérale (108) ;
- plusieurs premières grilles de commande (106) disjointes les unes des autres, disposées du côté de la première face latérale (108), les unes au-dessus des autres selon une direction perpendiculaire à la face supérieure du support (102) et définissant différents niveaux de grille, configurées pour commander chacune le potentiel électrostatique d'une des boîtes quantiques, la première grille de commande (106) la plus proche du support (102) étant disposée dans un niveau de grille N, et la première grille de commande (106) la plus éloignée du support (102) étant disposée dans un niveau de grille N+Z, avec N correspondant à un nombre entier supérieur ou égal à 1, et Z correspondant à un nombre entier supérieur ou égal à 2 ;
- au moins une deuxième grille de commande (114) disposée du côté de la deuxième face latérale (116), et configurée pour commander le potentiel électrostatique d'une région de couplage destinée à être formée entre les boîtes quantiques ;
dans lequel la ou les grilles de commande (114) disposées du côté de la deuxième face latérale (116) sont décalées, selon la direction perpendiculaire à la face supérieure du support (102), par rapport aux grilles de commande (106) disposées du côté de la première face latérale (108) et définissent un ou plusieurs niveaux de grille chacun interposé entre deux autres niveaux de grille comprenant chacun une des grilles de commande (106) disposées du côté de la première face latérale (108).

2. Dispositif électronique (100) selon la revendication 1, dans lequel une première partie (122) de la face supérieure du support (102) sur laquelle sont disposées les premières grilles de commande (106) est décalée, selon la direction perpendiculaire à la face supérieure du support (102), par rapport à une deuxième partie (124) de la face supérieure du support (102) sur laquelle est disposée la deuxième grille de commande (114).

3. Dispositif électronique (100) selon l'une des revendications précédentes, comportant plusieurs deuxièmes grilles de commande (114) disposées du côté de la deuxième face latérale (116) les unes au-dessus des autres selon la direction perpendiculaire à la face supérieure du support (102) et définissant différents niveaux de grille, configurées pour commander chacune le potentiel électrostatique d'une région de couplage destinée à être formée entre deux des boîtes quantiques,
dans lequel les deuxièmes grilles de commande (114) sont décalées, selon la direction perpendiculaire à la face supérieure du support (102), par rapport aux premières grilles de commande (106), chacune des deuxièmes grilles de commande (114) étant disposée dans un niveau de grille interposé entre deux autres niveaux de grille comprenant chacun une des premières grilles de commande (106).

4. Dispositif électronique (100) selon la revendication 3, comportant en outre plusieurs premières portions diélectriques (112) disposées entre les premières grilles de commande (106) et plusieurs deuxièmes portions diélectriques (120) disposées entre les deuxièmes grilles de commande (114).

5. Dispositif électronique (100) selon l'une des revendications 3 ou 4, dans lequel, selon une direction perpendiculaire aux faces latérales (108, 116), chacune des premières grilles de commande (106) comporte une largeur différente de celles des autres premières grilles de commande (106) et chacune des deuxièmes grilles de commande (114) comporte une largeur différente de celles des autres deuxièmes grilles de commande (114).

6. Dispositif électronique (100) selon l'une des revendications précédentes, dans lequel une dimension de l'ailette de semi-conducteur (104) perpendiculaire aux première et deuxième faces latérales (108, 116) est telle qu'un seul plan ou deux plans de boîtes quantiques parallèles aux première et deuxième faces latérales (108, 116) sont destinés à être formés dans l'ailette de semi-conducteur (104).

7. Dispositif électronique (100) selon l'une des revendications précédentes, dans lequel des hauteurs, selon la direction perpendiculaire à la face supérieure du support (102), des premières et deuxièmes grilles de commande (106, 114) sont égales les unes aux autres.

8. Dispositif électronique (100) selon l'une des revendications précédentes, dans lequel, dans un plan perpendiculaire à la face supérieure du support (102) et perpendiculaire aux première et deuxième faces latérales (108, 116), les premières et deuxièmes grilles de commande (106, 114) sont alignées les unes par rapport aux autres, ou les premières grilles de commande sont décalées par rapport aux deuxièmes grilles de commande.

9. Dispositif électronique (100) selon l'une des revendications précédentes, comprenant plusieurs ensembles distincts de premières et deuxièmes grilles de commande (106, 114) disposés le long d'une longueur de l'ailette de semi-conducteur (104) qui correspond à une dimension parallèle aux première et deuxième faces latérales (108, 116) et à la face supérieure du support (102).

10. Procédé de réalisation d'un dispositif électronique (100), comportant :
- réalisation d'une ailette de semi-conducteur (104) sur une face supérieure du support (102), dans laquelle des boîtes quantiques sont destinées à être formées, et comprenant une première face latérale (108) et une deuxième face latérale (116) opposée à la première face latérale (108) ;
- réalisation de plusieurs premières grilles de commande (106) disjointes les unes des autres, disposées du côté de la première face latérale (108), les unes au-dessus des autres selon une direction perpendiculaire à la face supérieure du support (102) et définissant différents niveaux de grille, configurées pour commander chacune le potentiel électrostatique d'une des boîtes quantiques, la première grille de commande (106) la plus proche du support (102) étant disposée dans un niveau de grille N, et la première grille de commande (106) la plus éloignée du support (102) étant disposée dans un niveau de grille N+Z, avec N correspondant à un nombre entier supérieur ou égal à 1, et Z correspondant à un nombre entier supérieur ou égal à 2 ;
- réalisation d'au moins une deuxième grille de commande (114) disposée du côté de la deuxième face latérale (116), et configurée pour commander le potentiel électrostatique d'une région de couplage destinée à être formée entre les boîtes quantiques ;
dans lequel la ou les grilles de commande (114) disposées du côté de la deuxième face latérale (116) sont décalées, selon la direction perpendiculaire à la face supérieure du support (102), par rapport aux grilles de commande (106) disposées du côté de la première face latérale (108) et définissent un ou plusieurs niveaux de grille chacun interposé entre deux autres niveaux de grille comprenant chacun une des grilles de commande (106) disposées du côté de la première face latérale (108).

11. Procédé selon la revendication 10, dans lequel la réalisation de l'ailette de semi-conducteur (104) comporte au moins une gravure du support (102), et dans lequel les premières et deuxièmes grilles de commande (106, 114) sont ensuite réalisées sur des parties restantes du support (102) disposées de part et d'autre de l'ailette de semi-conducteur (104).

12. Procédé selon la revendication 10, dans lequel la réalisation de l'ailette de semi-conducteur (104) comporte au moins une croissance épitaxiale à partir d'une région du support (102) formant une paroi de fond d'une ouverture (164) formée à travers un empilement de couches (160, 162) disposé sur le support (102) et à partir duquel les premières et deuxièmes grilles de commande (106, 114) sont réalisées.

13. Procédé selon l'une des revendications 10 ou 11, dans lequel la réalisation des premières et deuxièmes grilles de commande (106, 114) comporte au moins la mise en oeuvre des étapes suivantes :
- réalisation d'un empilement de couches d'un premier semi-conducteur (148) et de couches d'un deuxième semi-conducteur (150) disposées de manière alternée les unes au-dessus des autres, les premier et deuxième semi-conducteurs étant aptes à être gravés sélectivement l'un par rapport à l'autre ;
- gravure de l'empilement telle qu'au moins deux portions restantes de l'empilement soient chacune disposée contre l'une des première et deuxième parois latérales (108, 116) ;
- retrait sélectif de parties restantes des couches du deuxième semi-conducteur (150) présentes dans les portions restantes de l'empilement ;
- dépôt d'au moins un matériau diélectrique dans des espaces formés par le retrait sélectif des parties restantes des couches du deuxième semi-conducteur (150), formant des premières portions diélectriques (112) disposées entre les premières grilles de commande (106) et des deuxièmes portions diélectriques (120) disposées entre plusieurs deuxièmes grilles de commande (114) ;
et dans lequel l'ailette de semi-conducteur (104) est réalisée avant l'empilement.

14. Procédé selon l'une des revendications 10 ou 11, dans lequel la réalisation des premières et deuxième grilles de commande (106, 114) comporte au moins la mise en oeuvre des étapes suivantes :
- réalisation d'un empilement de couches d'un matériau électriquement conducteur et de couches d'un matériau diélectrique disposées de manière alternée les unes au-dessus des autres ;
- gravure de l'empilement telle qu'au moins deux portions restantes de l'empilement soient chacune disposée contre l'une des première et deuxième parois latérales (108, 116) ;
dans lequel l'empilement de couches est réalisé après l'ailette de semi-conducteur (104) et en mettant en oeuvre des étapes successives de dépôt des couches de matériau électriquement conducteur et des couches de matériau diélectrique et, entre les étapes de dépôt, des étapes de retrait de parties des couches de matériau électriquement conducteur et des couches de matériau diélectrique déposées contre les première et deuxième faces latérales (108, 116).

15. Procédé selon l'une des revendications 10 ou 11, dans lequel la réalisation des premières et deuxièmes grilles de commande (106, 114) comporte au moins la mise en oeuvre des étapes suivantes :
- réalisation d'un empilement de couches d'un matériau électriquement conducteur (160) et de couches d'un matériau diélectrique (162) disposées de manière alternée les unes au-dessus des autres ;
- gravure de l'empilement telle qu'au moins deux portions restantes de l'empilement de couches soient chacune disposée contre l'une des première et deuxième parois latérales (108, 116) ;
et dans lequel l'ailette de semi-conducteur (104) est réalisée après l'empilement.
